## Europäisches Patentamt
## European Patent Office
## Office européen des brevets

(19)

(11) Veröffentlichungsnummer: **0 166 815**
**A1**

(12) **EUROPÄISCHE PATENTANMELDUNG**

(21) Anmeldenummer: **84114905.7**

(22) Anmeldetag: **07.12.84**

(51) Int. Cl.⁴: **G 01 R 31/28**
**G 01 R 31/26**

(30) Priorität: **30.05.84 DE 3420269**

(43) Veröffentlichungstag der Anmeldung:
**08.01.86 Patentblatt 86/2**

(84) Benannte Vertragsstaaten:
**BE DE FR GB IT NL**

(71) Anmelder: **Siemens Aktiengesellschaft**
**Berlin und München Wittelsbacherplatz 2**
**D-8000 München 2(DE)**

(72) Erfinder: **Brust, Hans-Detlef**
**Martin-Luther-Strasse 2**
**D-6602 Dudweiler(DE)**

(54) **Verfahren und Vorrichtung zur Spektralanalyse eines Signals an einem Messpunkt.**

(57) Mit einem Verfahren und einer Vorrichtung zur Detektion und/oder Abbildung eines Meßpunktes, der eine Spannung wenigstens einer bestimmten Frequenz führt, bei denen in einem Raster-Korpuskularmikroskop ein Potentialkontrastsignal mitels eines "lock-in"-Verstärkers (LI) zu einem Meßsignal weiterverarbeitet wird, soll eine Spektralanalyse einer an dem Meßpunkt geführten Spannung auch dann möglich sein, wenn eine oder mehrere Frequenzen aus dem Spektrum dieses Signals unbekannt sind. Dem "lock-in"-Verstärker (LI) wird als Referenzsignal (REF) ein Signal zugeführt, dessen Frequenz (fb) über einen Frequenzbereich verändert wird. Einer Einrichtung (CRT) zum Aufzeichnen des Meßsignals wird ein Signal (SR) über die Größe der Frequenz (fb) des Referenzsignals (REF) übermittelt, so daß das Meßsignal in Abhängigkeit von der Frequenz (fb) des Referenzsignals (REF) angegeben werden kann.

Verfahren und Vorrichtung zur Spektralanalyse eines
Signals an einem Meßpunkt.

Die Erfindung betrifft ein Verfahren und eine Vorrichtung
zur Detektion und/oder qualitativen und/oder quantitativen
Abbildung eines Meßpunkts, der eine Spannung wenigstens
einer bestimmten Frequenz führt, nach dem Oberbegriff des
Anspruchs 1 und nach dem Oberbegriff des Anspruchs 5.

Bei fehlerhaftem Verhalten von integrierten Schaltungen besteht der Wunsch, zum Auffinden eines Fehlers das Verhalten
der integrierten Schaltung mit dem Soll-Verhalten, so wie
es sich aus der Simulation ergibt, zu vergleichen. Hierzu
muß u.a. überprüft werden, welche Frequenz oder welches Frequenzspektrum ein Signal an einem Meßpunkt innerhalb der
integrierten Schaltung aufweist.

Aus dem Stand der Technik sind bisher drei Verfahren bekannt, mit deren überprüft werden kann, ob bestimmte interne
periodische Signale bestimmter Frequenz an einem Meßpunkt
innerhalb einer integrierten Schaltung vorhanden sind. Aus
"Scanning Electron Microscopy" 1975 (part I), Proc. of the
Eigth Annual Scanning Electron Microscope Symposium, Chicago,
IIT Research Institute, Seiten 465-471, ist das Verfahren
des sogenannten "voltage coding" bekannt. Das "voltage coding"-Verfahren bildet die dynamische Potentialverteilung
einer integrierten Schaltung auf einem Fernsehmonitor ab.
Das "voltage coding"-Verfahren ermöglicht eine zeitliche
Zuordnung der Schaltzustände in den verschiedenen Bauelementen und ist daher besonders zur schnellen Funktionsüberprüfung von integrierten Schaltungen geeignet. Das "voltage
coding"-Verfahren hat jedoch

18.5.1984 / My 1 Bla

schwerwiegende Nachteile, die zwangsläufig durch die Zeilenfrequenz des Elektronenstrahls entstehen.

Aus der US-Patentschrift 4 223 220 ist das sogenannte "Logic State Mapping"-Verfahren bekannt. Bei dem "Logic State Mapping"-Verfahren wird die dynamische Potentialverteilung mit Hilfe eines Stroboskopeffekts abgebildet. Dieses "Logic State Mapping"-Verfahren liefert, verglichen mit dem "voltage coding"-Verfahren bei gleicher Potentialauflösung, eine um Größenordnungen höhere Zeitauflösung. Das "Logic State Mapping"-Verfahren vereinfacht außerdem die Aufzeichnung, da die Abbildungen der dynamischen Potentialverteilung direkt vom Fotobildschirm eines Raster-Elektronenmikroskops abfotografiert werden können. Bei dem "voltage coding"-Verfahren ist dagegen eine Aufzeichnung der dynamischen Potentialverteilung nur mit einem Bandspeicher oder mit Fotos von einem Fernsehmonitor möglich.

Nach einem dritten bekannten Verfahren (Verfahren von J.P. Collin in Proc. of Journée d'Électronique 1983, "Testing Complex Integrated Circuits: A Challenge", herausgegeben vom Swiss Federal Institute of Technology, Lausanne, Schweiz, Seiten 283-298, Titel: "Un Alternative Économique au Contraste de Potentiel Stroboscopique: Le Traitement du Signal d'Electrons Secondaires d'un Microscope a Balayage") wird das Auffinden bestimmter Frequenzen an einem Meßpunkt im Innern einer integrierten Schaltung unter Verwendung eines "lock-in"-Verstärkers durchgeführt. Dabei wird aus einem an einem Meßpunkt im Innern einer integrierten Schaltung gewonnenen Potentialkontrastsignal mit Hilfe des "lock-in"-Verstärkers ein Signal mit der gesuchten Frequenz ausgefiltert und dann die Intensität dieses Signals als Helligkeitsschwankung abgebildet.

Die drei genannten Verfahren, wie sie aus dem Stand der Technik bekannt sind, sind teilweise nur schwer durchführbar und erlauben teilweise nur eine Überprüfung einiger weniger Leitbahnen in der integrierten Schaltung. Überdies setzen die aus dem Stand der Technik bekannten Verfahren voraus, daß man die Frequenz eines zu suchenden Signals kennt bzw. daß ein zu dem zu suchenden Signal synchrones Signal von außen zugänglich ist. Ist die Frequenz eines gesuchten Signals unbekannt, so wird die Suche nach einem solchen Signal sehr mühsam und aufwendig. Dies ist z.B. dann der Fall, wenn die Frequenz eines zu suchenden Signals durch eine Teilung durch 255 statt durch eine Teilung durch 256 erzielt wird.

Der vorliegenden Erfindung liegt die Aufgabe zugrunde, ein Verfahren und eine Vorrichtung der eingangs genannten Art anzugeben, mit deren Hilfe eine Spektralanalyse einer an einem Meßpunkt geführten Spannung auch dann möglich ist, wenn eine oder mehrere Frequenzen aus dem Spektrum dieses Signals unbekannt sind.

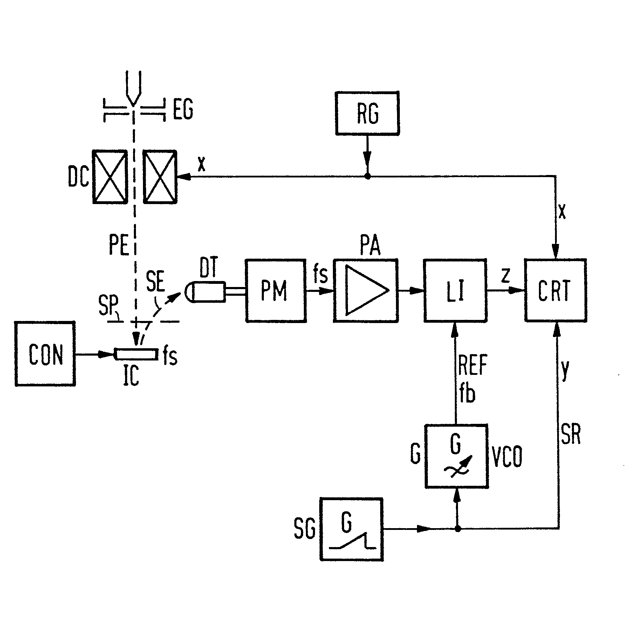

Diese Aufgabe wird erfindungsgemäß durch ein Verfahren nach dem Anspruch 1 und durch eine Vorrichtung nach dem Anspruch 5 gelöst. Ausgestaltungen und Vorteile der Erfindung sind in den Unteransprüchen, der Beschreibung und der Zeichnung dargestellt.

Durch Wobbeln der Referenzfrequenz des "lock-in"-Verstärkers kann man das in Frage kommende Frequenzspektrum durchfahren und so bei unbekannter Frequenz die auf einem Meßpunkt, beispielsweise einer Leiterbahn in einem integrierten Schaltkreis, auftretenden Frequenzen feststellen. Ein Verfahren und eine Vorrichtung nach der Erfindung ermöglichen eine Darstellung der innerhalb einer integrierten Schaltung vorkommenden Signalfrequenzen, falls eine oder mehrere Frequenzen eines gesuchten Signals nicht bekannt sind.

Ein Ausführungsbeispiel der Erfindung ist in der Zeichnung dargestellt und wird im folgenden näher beschrieben.

Die Figur zeigt eine Vorrichtung zur Spektralanalyse eines Signals an einem oder an mehreren Meßpunkten.

Obwohl sich das folgende Ausführungsbeispiel auf ein Elektronenmikroskop bezieht, ist die Erfindung so zu verstehen, daß anstelle von Elektronen auch Ionen oder andere Korpuskeln verwendet werden können, und zwar sowohl als Primärkorpuskeln als auch als Sekundärkorpuskeln.

Die Figur zeigt eine Vorrichtung zur Detektion und/oder qualitativen und/oder quantitativen Abbildung eines Meßpunkts oder einer Leiterbahn und der Ermittlung einer oder mehrerer Frequenzen, die im Frequenzspektrum eines Signals an einem Meßpunkt (Leiterbahn) enthalten sind. Aus einer Elektronenquelle EG treten Primärelektronen PE aus, die auf einen Meßpunkt (Leiterbahn) innerhalb eines integrierten Schaltkreises (IC) auftreffen und dort Sekundärelektronen SE auslösen. Diese Sekundärelektronen SE werden in einem Detektor DT nachgewiesen. In Abhängigkeit von dem Sekundärelektronenstrom, der auf den Detektor DT auftrifft, wird in diesem Detektor DT ein Sekundärelektronensignal erzeugt, das zu einem Fotomultiplier PM geführt und dort verstärkt wird. Das im Fotomultiplier PM verstärkte Sekundärelektronensignal wird weiter zu einem Vorverstärker PA geleitet. Das im Vorverstärker PA weiter verstärkte Sekundärelektronensignal gelangt schließlich in einen "lock-in"-Verstärker LI. Als "lock-in"-Verstärker LI kann beispielsweise ein Ithaco-Verstärker Typ 491A verwendet werden. Das Ausgangssignal dieses "lock-in"-Verstärkers LI kann beispielsweise die Intensität eines Elektronenstrahls in einer Bildröhre CRT steuern.

Die integrierte Schaltung IC wird von einer Ansteuerung CON aus mit einem Signal der Frequenz $n \cdot f_s$ angetrieben. Wenn der Strahl der Primärelektronen PE auf einen Meßpunkt innerhalb der integrierten Schaltung IC oder innerhalb einer sonstigen Probe trifft, und wenn dieser Meßpunkt ein Signal mit der zunächst unbekannten Frequenz $f_s$ führt, enthält auch der Strom der Sekundärelektronen SE, der letzten Endes als Sekundärelektronensignal dem "lock-in"-Verstärker zugeführt wird, ein Signalanteil mit der zunächst unbekannten Frequenz $f_s$. Aus diesem Sekundärelektronensignal kann daher im "lock-in"-Verstärker LI dieser Signalanteil mit der zunächst unbekannten Frequenz $f_s$ dann ausgefiltert werden, wenn dem "lock-in"-Verstärker LI als Referenzsignal REF ein Signal zugeführt wird, dessen Frequenz $f_b$ mit der zunächst unbekannten Frequenz $f_s$ im Frequenzspektrum des Sekundärelektronensignals übereinstimmt. Die Amplitude z dieses Signals mit der zunächst unbekannten Frequenz $f_s$, welches Bestandteil des Sekundärelektronensignals gewesen ist, kann dann, wenn die Frequenz $f_b$ des Referenzsignals REF mit dieser Frequenz $f_s$ übereinstimmt, als Ausgangssignal des "lock-in"-Verstärkers LI die Intensität des Elektronenstrahls in der Bildröhre CRT eines Raster-Elektronenmikroskops steuern. Gleichzeitig kann mit einem Signal SR, das dem Wert der Frequenz $f_b$ des Referenzsignals REF entspricht, ebenfalls die Bildröhre CRT oder eine andere Aufzeichnungseinrichtung, wie beispielsweise ein Rechner oder ein Plotter, angesteuert werden.

Über einen Rastergenerator RG kann die Ablenkeinrichtung eines Raster-Elektronenmikroskops angesteuert werden. Die Information darüber, auf welchen Meßpunkt einer Fläche der Strahl der Primärelektronen PE dadurch gerade abgelenkt worden ist, kann ebenfalls der Bildröhre CRT oder einem beliebigen anderen Aufzeichnungsgerät, wie beispielsweise einem
Rechner oder einem Plotter, zugeführt werden. Auf diese
Weise kann als Endergebnis einer Messung angegeben werden,
welcher Meßpunkt an welchem Ort innerhalb einer Probe welche
Frequenz fb führt. Wird bei der Detektion der Sekundärelektronen SE ein Spektrometer SP verwendet, wie es beispielsweise aus der US-Patentschrift 4 292 519 bekannt ist, so
lassen sich quantitative Messungen durchführen. Bei Verwendung eines solchen Spektrometers SP können zusätzlich in absoluten Zahlen Amplituden bestimmter Frequenzen in Frequenzspektren, die an verschiedenen Meßpunkten ermittelt werden,
verglichen werden. Die Erfindung ermöglich somit eine wirkliche Spektralanalyse, wobei Grundschwingungen und Oberschwingungen von Signalen aufgrund der Intensität der einzelnen Fourier-Komponenten unterschieden werden können. Zur
Darstellung der einzelnen Fourier-Komponenten eines Signals
an einem Meßpunkt wird sinnvollerweise die Frequenz fb an
einer Bildröhre CRT in x-Richtung und die Signalhöhe der
Fourier-Komponenten in y-Richtung der Bildröhre CRT aufgetragen. Wenn das Referenzsignal REF eine aktuelle Frequenz
fb aufweist, entspricht das zugehörige Ausgangssignal des
"lock-in"-Verstärkers LI der Signalhöhe der zu der Frequenz
fb gehörenden Fourier-Komponente im Spektrum des Signals am
gerade überprüften Meßpunkt. Sollen anstelle eines einzigen
Meßpunkts mehrere Meßpunkte (Leitbahnen) sukzessive oder
kontinuierlich auf das Frequenzspektrum der in ihnen geführten Signal hin überprüft werden, so ist als Aufzeichnungsmedium einer Bildröhre CRT ein Rechner vorzuziehen.

Bei Verwendung eines Rechners als Aufzeichnungsmedium können
auch Meßpunkte in einer zweidimensionalen Fläche mit dem
Strahl der Primärelektronen PE abgerastert werden, solange
Information über die jeweils aktuelle Frequenz fb und sofern Information über die Position des Strahls der Primärelektronen PE in den Rechner oder in ein anderes Aufzeichnungsmedium eingegeben werden.

Tastet der Strahl der Primärelektronen PE Meßpunkte auf einer Probe nur entlang einer Linie (beispielsweise in x-Richtung) ab, so kann der eindimensionalen Variation des Auftreffortes des Strahles der Primärelektronen PE auf der Probe eine Variation der Frequenz fb überlagert werden. Zu diesem Zweck erzeugt ein Generator SG ein Rampensignal oder ein Treppensignal SR. Dieses Rampensignal oder Treppensignal SR wird einem Eingang der Bildröhre CRT zugeführt und steuert zugleich einen spannungsabhängigen Oszillator (VCO = voltage controlled oscillator) G an. Der Generator G liefert das Referenzsignal REF mit einer solchen Frequenz fb, die der Größe des Rampensignals SR entspricht. Der Strahl der Primärelektronen PE tastet ständig kontinuierlich oder sprungweise entlang einer Linie (line scan) in x-Richtung, während zugleich die Frequenz fb des Referenzsignals REF den in Frage kommenden Frequenzbereich überstreicht. Eine der aktuellen Frequenz fb proportionale Spannung SR lenkt gleichzeitig den Elektronenstrahl in der Bildröhre CRT in y-Richtung ab. Immer dann, wenn die Frequenz fb den Wert einer Frequenz fs erreicht, die im Frequenzspektrum eines Signals an einem Meßpunkt vorhanden ist, erscheint auf dem Bildschirm der Bildröhre CRT ein Strich und man erhält so eine Darstellung der Frequenzen fs, die die abgetasteten Meßpunkte führen. Wenn dem "lock-in"-Verstärker Ll eine Komparatorschaltung nachgeschaltet wird, erscheinen die Striche auf dem Bildschirm CRT hell. Anderenfalls wird der Grauwert des jeweiligen Striches durch die Größe der jeweiligen Fourier-Komponente bestimmt.

Der Strahl der Primärelektronen PE kann eine Gruppe von Meßpunkten mehrfach hintereinander jeweils so rasch abtasten, daß sich der Wert der Frequenz fb bei einem einmaligen Abtasten dieser Gruppe von Meßpunkten um nicht mehr als 3 kHz ändert. Die maximal zulässige Frequenzänderung wird durch das Verhältnis von Sweep-Weite und Eingangsbandbreite des "lock-in"-Verstärkers LI bestimmt.

Schließlich können noch die Geschwindigkeitsverhältnisse von Strahlablenkung der Primärelektronen PE und Überstreichen eines Frequenzbereichs bezüglich der Frequenz fb umgekehrt werden. Die Strahlablenkung der Primärelektronen PE kann dabei wiederum entweder kontinuierlich oder durch Springen zwischen mehreren Meßpunkten (Leiterbahnen) erfolgen. Dazu wird z.B. der Strahl der Primärelektronen PE zunächst auf den ersten Meßpunkt (Leiterbahn) positioniert und wird sodann bezüglich der Frequenz fb der interessierende Frequenzbereich durchgefahren. Daraufhin springt der Strahl der Primärelektronen PE zum nächsten Meßpunkt (Leiterbahn), wo erneut die Frequenz fb durchgewobbelt wird.

Als Grundgerät für eine Vorrichtung nach der Erfindung oder zur Durchführung eines Verfahrens nach der Erfindung kann ein Raster-Elektronenmikroskop verwendet werden, wie es aus den US-PSn mit den Nummern 4 220 853 bzw. 4 220 854 bzw. 4 277 679 für eine quantitative Potentialmessung und aus der US-PS 4 223 220 für eine qualitative Potentialmessung bekannt ist.

Grundsätzlich kann anstelle des "lock-in"-Verstärkers LI jedes durchstimmbare Filter treten, dessen Mittenfrequenz sich durch ein Steuersignal verändern läßt. Hierfür kommen beispielsweise "switched-capacitor"-Filter oder ein Mischer mit nachgeschaltetem Bandfilter in Betracht.

## Patentansprüche:

1. Verfahren zur Detektion und/oder qualitativen und/oder quantitativen Abbildung eines Meßpunkts, der eine Spannung wenigstens einer Frequenz (fs) führt, mit Hilfe eines Korpuskularmikroskops, in dem der Meßpunkt mit Primärkorpuskeln (PE) beaufschlagt wird, in dem Sekundärkorpuskeln (SE), die von den Primärkorpuskeln (PE) am Meßpunkt ausgelöst werden, in einem Detektor (DT) nachgewiesen werden, und in dem ein daraus sich ergebendes Sekundärkorpuskelsignal mittels eines "lock-in"-Verstärkers (LI) zu einem Meßsignal weiterverarbeitet wird,
dadurch gekennzeichnet ,
- daß dem "lock-in"-Verstärker (LI) als Referenzsignal (REF) ein Signal zugeführt wird, dessen Frequenz (fb) über einen Frequenzbereich verändert wird, und
- daß einer Einrichtung (CRT) zum Aufzeichnen des Meßsignals ein Signal (SR) über die Größe der Frequenz (fb) des Referenzsignals (REF) übermittelt wird, so daß das Meßsignal in Abhängigkeit von der Frequenz (fb) des Referenzsignals (REF) angegeben werden kann.

2. Verfahren nach Anspruch 1, dadurch gekennzeichnet , daß der Strahl der Primärkorpuskeln (PE) abgelenkt wird und daß der Einrichtung (CRT) zur Aufzeichnung des Meßsignals eine zusätzliche Information (x) über den Ort des Meßpunkts übermittelt wird, so daß das Meßsignal auch noch in Abhängigkeit vom Ort des Meßpunkts angegeben werden kann.

3. Verfahren nach Anspruch 1 oder 2, dadurch gekennzeichnet , daß der Strahl der Primärkorpuskeln (PE) immer wieder von neuem eine Gruppe von Meßpunkten abtastet, daß dabei die Frequenz (fb) des Referenzsignals (REF) geändert wird und daß die Frequenz (fb) bei einmaligem Abtasten der Gruppe von Meßpunkten sich in ihrem Wert um weniger als 3 kHz ändert.

4. Verfahren nach Anspruch 1 oder 2, dadurch g e - k e n n z e i c h n e t , daß der Strahl der Primärkorpuskeln (PE) auf einen einzigen Meßpunkt gerichtet wird und daß dabei die Frequenz (fb) des Referenzsignals (REF) einen Frequenzbereich überstreicht.

5. Vorrichtung zur Detektion und/oder qualitativen und/oder quantitativen Abbildung eines Meßpunkts, der eine Spannung wenigstens einer Frequenz (fs) führt, mit Hilfe eines Korpuskularmikroskops, mit einer Korpuskularquelle (EG) zur Emission von Primärkorpuskeln (PE), mit einem Detektor (DT) zur Detektion von Sekundärkorpuskeln (SE), die an einem Meßpunkt einer Probe (IC) von den Primärkorpuskeln (PE) ausgelöst worden sind, mit einem Fotomultiplier (PM) und mit einem "lock-in"-Verstärker (LI) zur Verarbeitung eines sich im Detektor (DT) ergebenden Sekundärelektronensignals, mit einer Einrichtung (CRT) zur Aufzeichnung eines sich am Ausgang des "lock-in"-Verstärkers (LI) ergebenden Meßsignals und mit einer Ansteuerung (CON) zur Ansteuerung der Probe (IC) mit einem Signal einer Frequenz (fs), g e k e n n z e i c h n e t durch eine Einrichtung (G) zur Erzeugung eines eine variable Frequenz (fb) aufweisenden Referenzsignals (REF) für den "lock--in"-Verstärker (LI) und zur gleichzeitigen Ansteuerung einer Aufzeichnungsvorrichtung.

6. Vorrichtung nach Anspruch 5, g e k e n n z e i c h - n e t durch einen Generator (SG) zur Erzeugung eines veränderlichen Signals (SR) zur Ansteuerung einer Einrichtung (CRT) zur Aufzeichnung des Meßsignals und zur Ansteuerung des Generators (G), der das Referenzsignal (REF) mit variabler Frequenz (fb) in Abhängigkeit von dem Rampensignal (SR) erzeugt.

7. Vorrichtung nach Anspruch 5 oder 6, g e k e n n - z e i c h n e t durch einen Rastergenerator (RG) zur Ansteuerung einer Einrichtung (DC) zur Ablenkung des Strahls der Primärkorpuskeln (PE) und zur Ansteuerung der Einrichtung (CRT) zur Aufzeichnung des Meßsignals.

8. Vorrichtung nach einem der Ansprüche 5 bis 7, g e - k e n n z e i c h n e t durch ein Spektrometer (SP) zur quantitativen Messung des Sekundärelektronensignals.

9. Vorrichtung nach einem der Ansprüche 5 bis 8, dadurch g e k e n n z e i c h n e t , daß dem "lock-in"-Verstärker (LI) eine Komparatorschaltung zur Kontrastverbesserung nachgeschaltet ist.

10. Vorrichtung nach einem der Ansprüche 5 bis 7, g e - k e n n z e i c h n e t durch ein Gegenfeldspektrometer (SP) mit einer konstanten Spannung an der Gegenfeldelektrode.

# EUROPÄISCHER RECHERCHENBERICHT

Europäisches
Patentamt

## EINSCHLÄGIGE DOKUMENTE

| Kategorie | Kennzeichnung des Dokuments mit Angabe. soweit erforderlich, der maßgeblichen Teile | Betrifft Anspruch | KLASSIFIKATION DER ANMELDUNG (Int. Cl 4) |
|---|---|---|---|
| Y | IBM TECHNICAL DISCLOSURE BULLETIN, Band 12, Nr. 12, Mai 1970, Seite 2229, New York, US; D.P. GAFFNEY: "Detection od small potential differences in a scanning electron microscope" * Insgesamt * | 1-2,5, 6 | G 01 R 31/28 G 01 R 31/26 |
| Y | MICROWAVE JOURNAL, Band 26, Nr. 4, April 1983, Seiten 125-127,130-133, Dedham, Mass., US; T. PECCOLO: "The spectrum analyzer comes of age" * Seite 125, Bild 1 * | 1-2,5, 6 | |
| A | IEEE TRANSACTIONS ON ELECTRON DEVICES, Band ED-26, Nr. 4, April 1979, Seiten 549-559, New York, US; E. WOLFGANG et al.: "Electron-beam testing of VLSI CIRCUITS" * Seite 553, Bild 5; linke Spalte, Absatz 1 * | 4,7 | RECHERCHIERTE SACHGEBIETE (Int Cl 4) G 01 R H 01 J |
| A | ELECTRONICS, Band 54, Nr. 14, 14. Juli 1981, Seiten 105-112, New York, US; P. FAZEKAS et al.: "Scanning electron beam probes VLSI chips" * Seite 109, Bild 5; rechte Spalte, Absatz 1 * | 8,10 | |

Der vorliegende Recherchenbericht wurde für alle Patentanspruche erstellt.

| Recherchenort DEN HAAG | Abschlußdatum der Recherche 11-09-1985 | Prüfer KAUFFMANN J. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82